# EUROPÄISCHE PATENTANMELDUNG

(11) **EP 2 768 293 A1**
(43) Veröffentlichungstag der Anmeldung: **20.08.2014**
(21) Anmeldenummer: 14152093.2
(22) Anmeldetag: 22.01.2014
(51) Int. Cl.: H05K 3/34, H05K 3/40

(54) **Leiterplatte für elektrische Schaltungen**

(30) Priorität: 15.02.2013 DE 202013001560 U
(71) Anmelder: Automotive Lighting Reutlingen GmbH, 72762 Reutlingen (DE)
(72) Erfinder: Johann, Christian, 72770 Reutlingen (DE)
(74) Vertreter: DREISS Patentanwälte PartG mbB

(57) **Zusammenfassung**

Die Erfindung betrifft eine Leiterplatte (10) für elektrische Schaltungen, wobei die Leiterplatte (10) auf mindestens einer Oberfläche eine Lötstopmaske (20) mit Aussparungen für Lötstellen (24) zum Kontaktieren von elektrischen Bauelementen (26), und Leiterbahnen aufweist, wobei mindestens eine der Lötstellen (24) mehrere Schichten (38, 40, 42) aus unterschiedlichen Materialien umfasst und der mehrschichtige Aufbau der Lötstellen (24) sich von dem Aufbau der restlichen Leiterplatte (10) unterscheidet.

## Beschreibung

Die vorliegende Erfindung betrifft eine Leiterplatte für elektrische Schaltungen, wobei die Leiterplatte auf mindestens einer Oberfläche eine Lötstopmaske mit Aussparungen für Lötstellen zum Kontaktieren von elektrischen Bauelementen und Leiterbahnen aufweist.

Eine Leiterplatte (auch Leiterkarte, Platine, gedruckte Schaltung oder PCB, Printed Circuit Board genannt) ist ein Träger für elektrische, insbesondere elektronische Bauelemente. Sie dient der mechanischen Befestigung und der elektrischen Kontaktierung der Bauelemente über Leiterbahnen, die auf oder in der Leiterplatte verlaufen.

Leiterplatten umfassen als Basismaterial elektrisch isolierendes Material, auf bzw. in dem elektrisch leitende Verbindungen (sog. Leiterbahnen) ausgebildet sind. Als isolierendes Material ist bspw. faserverstärkter Kunststoff üblich. Das Basismaterial war früher oft Pertinax

(Phenolharz mit Papierfasern, sog. Hartpapier, Materialkennung FR2). Heute werden - außer für billige Massenartikel - meist mit Epoxidharz getränkte Glasfasermatten (Glasvlies) verwendet (Materialkennung FR4). Materialbezeichnungen für das Basismaterial (FR steht für flame retardant):
- FR1 = Phenolharz + Papier (billige Sorte)
- FR2 = Phenolharz + Papier (Standard-Qualität)
- FR3 = Epoxidharz + Papier (etwas hochwertiger: CEM-Material)
- FR4 = Epoxidharz + Glasfasergewebe
- FR5 = Epoxidharz + Glasfasergewebe (wärmebeständiger).
Für Spezialanwendungen kommen auch andere Materialien zum Einsatz, wie beispielsweise Teflon, Aluminium oder Keramik in LTCC (Niedertemperatur-Einbrand-Keramiken) und HTCC (Hochtemperatur-Mehrlagenkeramik) für die Hochfrequenztechnik sowie Polyesterfolie oder Polyimid für flexible Leiterplatten. Neueste Entwicklungen setzen auch Glas als Basismaterial ein, für Leiterplatten mit hohen Anforderungen an die Wärmeabführung werden Basismaterialien mit elektrisch isolierten Metallkernen wie Aluminium verwendet, z.B. im Bereich der Beleuchtungstechnik mit Hochleistungsleuchtdioden. Diese Trägermaterialien werden auch als "Direct Bonded Copper" oder als "Insulated Metal Substrate" (IMS) bezeichnet.

Die Bauelemente werden z.B. auf Lötflächen (sog. Pads) gelötet. So werden die Bauelemente gleichzeitig mechanisch fixiert und elektrisch kontaktiert. Größere Bauelemente können auch mit Kabelbindern, Klebstoff oder Verschraubungen auf der Leiterplatte befestigt werden.

In Kraftfahrzeugen wirken mechanische Kräfte auf die Leiterplatte und/oder die darauf befestigten Bauelemente. Diese können ihren Grund bspw. in räumlichen Temperaturunterschieden, zeitlichen Temperaturschwankungen, Schwingungen oder Vibrationen vom Motor oder dem Fahrwerk, Schlägen oder Stößen von der Fahrbahn haben. Die Folge kann eine mechanische und/oder thermische Überbeanspruchung und nachfolgend eine Fehlfunktion bis hin zu einem Komplett-Ausfall der Leiterplatte sein.

Dabei können folgende Komponenten betroffen sein:
- Schaltungsträger (elektrische Verbindungen bzw. Leiterbahnen zwischen den Bauteilen) oder Leiterplatten-Substrate z.B. FR4-Material, wobei diese wiederum auf weiteren Materialien z.B. Aluminiumblech, Kühlkörper o.ä. angeordnet sein können;
- Elektrische Komponenten, bevorzugt oberflächenmontierte Bauelemente (sog. SMDs, Surface-Mounted Devices), wie bspw. Widerstände, ICs (integrierte Schaltungen), Kondensatoren;
- Elektrisch leitfähige Verbindungen zwischen den Schaltungsträgern auf der Leiterplatte (z.B. Kleber, Lote, etc.)

Mechanische Kräfte können dabei auftreten durch:
- Thermische Ausdehnung (räumliche Temperaturunterschiede, unterschiedliche Ausdehnungskoeffizienten der Komponenten, zeitliche Temperaturschwankungen)
- Verformung, z.B. Biegung durch externe Krafteinwirkung (im Fertigungsprozess oder während der bestimmungsgemäßen Verwendung, Vibrationen, etc.)

Für die thermische Beanspruchung sind zu berücksichtigen:
- Temperaturhub während der Herstellung, während der Erprobung, während des Betriebs;
- Ausdehnungskoeffizient, ggf. als Funktion der Temperatur;
- Anzahl der Temperaturzyklen;
- Gradient der Temperaturänderung;
- Verweildauer bei Grenztemperaturen.

Eine beispielhafte Leiterplatte aus dem Stand der Technik, die insbesondere für Anwendungen im Kraftfahrzeugbereich vorgesehen ist, könnte z.B. als eine dünne FR4-Leiterplatte (3-lagig, Dicke ca. 0,3 mm) ausgebildet sein, die mittels einer Verklebung (sog. Bonding Sheet) auf eine ca. 1,5 mm starke Aluminiumplatte laminiert ist. Auf einer Bestückungsseite der Leiterplatte ist zumindest im Bereich von Lötstellen jeweils eine Materialschicht aus Kupfer, Nickel und Gold vorgesehen. Die Nickel- und Goldschicht ist als sog. ENIG-Schicht (Electroless Nickel /Immersion Gold) bekannt. Zum Verlöten der Bauelemente wird ein Lot verwendet, bspw. ein bleifreies Lot (z.B. sog. Innolot). Bleifreie Lote sind hinsichtlich Temperaturwechselbelastbarkeit problematischer als herkömmliche bleihaltige Lote, die allerdings zwischenzeitlich gesetzlich weitgehend verboten sind.

Bestimmte elektrische Bauelemente sind wegen ihres Materials oder/und der Gehäusebauform problematisch hinsichtlich einer Temperaturwechselbelastbarkeit und/oder eines mechanischen Stress (Krafteinwirkung von außen, Stöße, Vibrationen, etc.). Dies sind zum Beispiel:
- Keramikkondensatoren, insbesondere Vielschicht-Chip-Kondensatoren (sog. MLCCs, Multi Layer Ceramic Capacitor), die als SMDs ausgebildet sind. Insbesondere größere Bauformen sind betroffen, die vom Design her kaum eine Fähigkeit aufweisen, unterschiedliche thermisch bedingte Ausdehnungen oder externe mechanische Kräfte zu kompensieren.
- QFN-Bauelemente (Quad Flat No Leads), die ein im Wesentlichen quadratisches Kunststoffgehäuse mit Anschlüssen an der Unterseite aufweisen. Die Anschlüsse sind nach dem Verlöten nicht mehr sichtbar. Die Bauelemente weisen teilweise deutliche Unterschiede in den thermischen Ausdehnungskoeffizienten sowohl innerhalb eines Bauelements als auch bezüglich des Leiterplatten-Materials auf. Vom Design her können sie die unterschiedlichen Ausdehnungen kaum kompensieren.

In beiden Fällen werden mechanische Spannungen auf die Leiterplatte übertragen.

Je nach mechanischer Festigkeit der einzelnen Bauelemente wirken daher Kräfte im Bauelement selbst oder an der Lötstelle, die zu Fehlern, Defekten und Ausfällen des Bauelements führen können. Zwei Fehlerbilder sind dabei typisch:
- Ausfall eines Keramikkondensators, wobei der Ausfall durch externe mechanische Belastung bereits im Fertigungsprozess (z.B. Biegeprozess) initiiert worden ist. Dies führt in der Regel zu einem Frühausfallverhalten.
- Ausfall einer Lötstelle im Bereich von QFN-Bauelementen, wobei ein Lebensdauerende der Lötstelle dadurch erreicht wird, dass die Lötstelle durch andauernd dort angreifende Kräfte elektrisch unterbrochen wird.

Um den Ausfall z.B. der Keramikkondensatoren zumindest zu verzögern und eine mechanische Belastbarkeit zu verbessern, ist es bekannt, die mechanischen Kräfte, die über die Terminierung auf den Keramikgrundkörper einwirken können, durch eine zusätzliche, ausgleichende Schicht im Bauelement zu dämpfen bzw. zu kompensieren.

Vor diesem Hintergrund stellt sich die Aufgabe, eine Leiterplatte derart auszugestalten und weiterzubilden, dass die Lebensdauer von Leiterplatten und der darauf befestigten Bauelemente, insbesondere unter Extrembelastungen, wie sie in einem Kraftfahrzeug auftreten können, verlängert wird.

Zur Lösung der Aufgabe wird ausgehend von der Leiterplatte der eingangs genannten Art vorgeschlagen, dass mindestens eine der Lötstellen mehrere Schichten aus unterschiedlichen Materialien umfasst und der mehrschichtige Aufbau der Lötstellen sich von dem Aufbau der restlichen Leiterplatte unterscheidet.

Erfindungsgemäß wird also vorgeschlagen, dass dämpfende und kräfteabsorbierende Mittel bereits in die Leiterplatte, insbesondere im Bereich der Lötstellen, eingebracht sind. Lötstellen auf der Leiterplatte sind seit jeher problematische Bereiche, die oft zumindest ein Fehlverhalten, wenn nicht sogar einen Ausfall der Leiterplatte verursachen können. Eine Suche nach dem entsprechenden Fehler ist oft sehr aufwendig. Die Ursache dafür kann schon im Herstellungsverfahren z.B. bei der Bestückung der Leiterplatte liegen, kann aber auch im laufenden Betrieb durch Umgebungseinflüsse (Temperatur, mechanische Belastung) begründet sein. Die erfindungsgemäß beanspruchten unterschiedlichen Schichten im Bereich der Lötstelle können eine Veränderung der physikalischen Eigenschaften der Leiterplatte, insbesondere im Bereich der Lötstelle, bewirken. Dadurch kann die Leiterplatte belastbarer eingesetzt werden, so dass die Lebensdauer der Leiterplatte verlängert werden kann.

Die erfindungsgemäße Leiterplatte weist in der Regel einen nichtleitenden, plattenförmig ausgebildeten Kern, z.B. eine mit Epoxidharz getränkte Glasfasermatte (sog. FR4-Material) auf, auf dem Leiterbahnen z.B. aus Kupfer angeordnet sind. Die Leiterbahnen sind außerhalb der vorgesehenen Lötstellen bevorzugt mit einer isolierenden Schicht, z.B. einer Lötstoppmaske, bedeckt. Die mehrschichtigen Lötstellen selbst sind in den von der Lötstoppmaske freigelassenen Bereichen vorzugsweise bis zu einer Oberfläche der angrenzenden Leiterplattenbereiche zur elektrisch leitenden Kontaktierung von Bauelementen ausgebildet.

In einer bevorzugten Ausführungsform der Erfindung ist vorgesehen, dass mindestens eine Schicht der Lötstellen eine elektrisch leitende, elastische Materialschicht ist. Diese Schicht kann bspw. ein Harz, insbesondere ein Kunstharz, bspw. Epoxidharz, umfassen. In dem verwendeten Material sind dabei elektrisch leitfähige Partikel bspw. aus Silber oder Kupfer untergemischt, um die elektrische Leitfähigkeit sicherzustellen bzw. zu verbessern.

Die elastische Materialschicht dient dazu, die Leiterplatte im Bereich der Lötstelle gegenüber mechanischer und thermischer Beanspruchung widerstandsfähiger auszugestalten. Mechanische Beanspruchung kann durch von außen auf die Leiterplatte wirkenden Druck, z.B. durch eine Haltevorrichtung oder einen Greifer, hervorgerufen werden. Außerdem ist es denkbar, dass Vibrationen, Stöße und/oder Schläge zu einer mechanischen Beanspruchung führen. Eine thermische Beanspruchung kann aufgrund unterschiedlicher Ausdehnungskoeffizienten der Materialien eines Bauteils und/oder der Leiterplatte zu Spannungen und damit zum Auftreten mechanischer Kräfte führen. Die thermische Beanspruchung kann durch räumliche Temperaturunterschiede und/oder zeitliche Temperaturschwankungen hervorgerufen werden. Dabei können die Schwankungen bzw. Unterschiede durch die Temperatur im Umfeld der Leiterplatte und/oder durch das Aufheizen der Bauelemente auf der Leiterplatte während des Betriebs hervorgerufen werden. Durch eine kompakte Bauweise sind teilweise Bauelemente mit unterschiedlichen Wärmeausdehnungskoeffizienten dicht nebeneinander auf der Leiterplatte angeordnet, was zu thermomechanischen Spannungen auf der Leiterplatte, insbesondere im Bereich der Lötstellen führen kann. Dies ist besonders dann gegeben, wenn oberflächenmontierbare Bauelemente (sog. SMDs) auf der Leiterplatte verlötet sind. Derartige Leiterplatten sind oft besonders kompakt ausgeführt und bestückt, da sie zweiseitig mit Bauelementen bestückbar sind. Die oberflächenmontierbaren Bauelemente (z.B. Keramikkondensatoren oder QFN-Bauelemente mit entsprechenden Anschlüssen, den sog. Footprints) lassen konstruktionsbedingt nach dem Verlöten in der Regel keine längenausgleichende Bewegung des Bauelements bzw. deren Kontaktierungselemente zu.

Die elastische Materialschicht kann diese mechanischen und/oder thermomechanischen Belastungen zumindest teilweise kompensieren, sodass z.B. eine temperaturabhängige Zyklenfestigkeit des Bauelements erhöht wird. Dies kann während eines Temperaturdauerlaufs nachgewiesen werden. Auch kann ein Bruch z.B. eines Keramikkondensators vermieden oder zumindest zeitlich hinausgezögert werden. Ebenso kann eine schleichende, kontinuierliche Verschlechterung der Lötstelle (Degradation) verlangsamt werden. Eine eventuell mögliche Rissbildung in der Lötstelle kann ebenso verhindert werden.

Um eine gewünschte Elastizität durch die elektrisch leitende, elastische Materialschicht zu erreichen, ist vorgesehen, dass die elastische Materialschicht ein Elastizitätsmodul (Elastizitätskoeffizient) zwischen 2000 und 6000 N/mm², bevorzugt zwischen 2000 und 3000 N/mm² aufweist.

In einer weiteren bevorzugten Ausführungsform ist ferner vorgesehen, dass die elektrisch leitende, elastische Materialschicht auf einer Kupferschicht angeordnet ist. Die Kupferschicht ist bevorzugt zusätzlich mit Kupfer beschichtet (plattiniert). Die Kupferschicht stellt dabei eine elektrische Verbindung zu einer in der Leiterplatte angeordneten Leiterbahn dar.

Weiterhin ist vorgesehen, dass die elektrisch leitende, elastische Materialschicht zwischen der Kupferschicht und einer Nickelschicht angeordnet ist. Dabei kann die Nickelschicht Teil einer sog. ENIG-Schicht (Electroless Nickel /Immersion Gold) sein. Das bedeutet, dass die Nickelschicht vorzugsweise eine Goldauflage aufweist. Es ist denkbar, das Gold durch andere geeignete Materialien wie z.B. Zinn zu ersetzen. Die Auflage aus Gold, Zinn oder einem anderen geeigneten Material ermöglicht ein ordnungsgemäßes Mehrfachlöten an der Luft, ohne dass die Lötverbindung negativ beeinträchtigt wird.

Zum Verlöten der insbesondere oberflächenmontierten Bauelemente wird bevorzugt ein bleifreies Lot (z.B. sog. Innolot) verwendet. Dabei bildet sich eine im Wesentlichen starre Anordnung zwischen dem Bauelement und der Leiterplatte, wobei insbesondere die elektrisch leitende, elastische Materialschicht der Lötstelle die mechanischen und thermomechanischen Belastungen kompensieren kann. Die ENIG-Schicht ist elastisch genug, um die Kompensation der Belastungen durch die elastische Materialschicht nicht zu behindern.

Ein bevorzugtes Ausführungsbeispiel der vorliegenden Erfindung ist in der nachfolgend beschriebenen Zeichnung näher erläutert. Es zeigt:

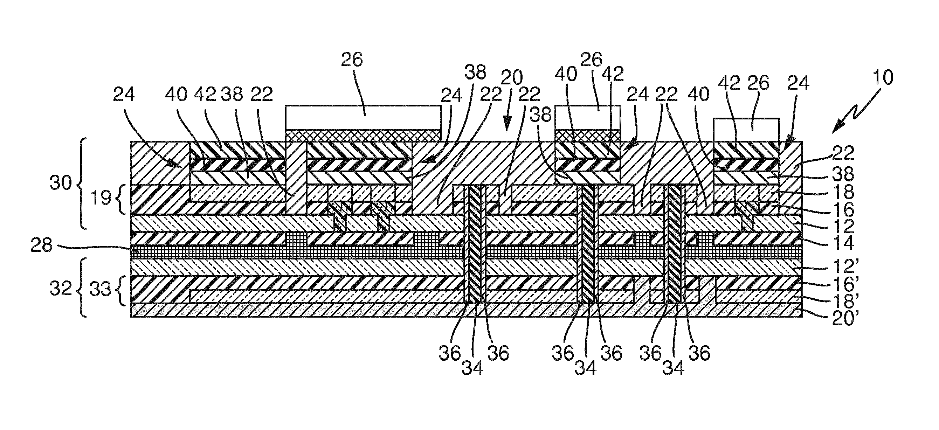

Fig. 1 eine schematische Darstellung einer erfindungsgemäßen Leiterplatte in einem Längsschnitt.

In Figur 1 ist eine erfindungsgemäße Leiterplatte in ihrer Gesamtheit mit dem Bezugszeichen 10 bezeichnet. Wie man anhand des Längsschnitts erkennen kann, ist die Leiterplatte 10 mehrschichtig aufgebaut. Die einzelnen Schichten der Leiterplatte 10 könnten zumindest teilweise oder bereichsweise anders aufgebaut sein als in Figur 1 gezeigt.

Gemäß dem gezeigten Beispiel weist die Leiterplatte 10 mindestens eine Kernschicht 12 auf, die bspw. ein mit Epoxidharz getränktes Glasfaservlies (sog. FR4-Material) umfasst. In dem Beispiel verfügt die Leiterplatte 10 sogar über zwei Kernschichten 12, 12'. Auf der Kernschicht 12 ist beidseitig jeweils eine Kupferschicht 14, 16 angeordnet, die zu verschiedenen Leiterbahnen ausgebildet ist. Die Leiterbahnen können bspw. in die Kupferschicht 14, 16 geätzt werden. Der Verlauf der Leiterbahnen ist durch die technischen Gegebenheiten auf der Leiterplatte 10, insbesondere durch die Funktion der Schaltung, Art und Anordnung der verwendeten Bauelemente, etc. vorgegeben. Die Kupferschicht 16 ist zusätzlich mit Kupfer 18 beschichtet (plattiniert). Die Leiterbahnen, die aus den beiden Kupferschichten 16, 18 gebildet sind, stellen die elektrischen Verbindungen in der Oberschicht 19 (Top-Layer) der Leiterplatte 10 dar.

Auf der oberen Kupferschicht 18 ist eine Lötstoppmaske 20, bevorzugt in Form eines Lötstopplacks, aufgetragen. Die Lötstoppmaske 20 spart den Bereich von Lötstellen aus und grenzt diese voneinander ab. Sie dient zum Schutz der Leiterplatte 10 vor Korrosion und mechanischer Beschädigung und verhindert beim Löten das Benetzen der mit dem Lötstopplack überzogenen Flächen mit Lot sowie einen elektrischen Schluss mit anderen Lötstellen. Die Lötstoppmaske 20 durchdringt an definierten Positionen 22 die Kupferschichten 16, 18 und grenzt damit auch die Leiterbahnen voneinander ab.

In der Lötstoppmaske 20 sind Aussparungen für Lötstellen 24 zum Kontaktieren von Bauelementen 26 ausgebildet. Die Bauelemente 26 sind bevorzugt oberflächenmontierbare Bauelemente (sog. SMDs, Surface Mounted Devices), z.B. Keramikkondensatoren oder QFN (Quad Flat No Leads)-Bauelemente mit entsprechenden Kontaktierungselementen (sog. Footprints).

Auf der Kupferschicht 14 ist auf der von der Kernschicht 12 abgewandten Seite eine Kleberschicht 28 angeordnet, welche die Möglichkeit bietet, die Leiterplatte 10 mit zusätzlichen Schichten derart auszubilden, dass sie beidseitig bestückt werden kann. Die Klebeschicht 28 umfasst bspw. Epoxidharz. Die Kleberschicht 28 teilt die Leiterplatte 10 in eine erste Seite 30 zur Kontaktierung von Bauelementen 26 und in eine zweite, gegenüberliegende Seite 32 zur Kontaktierung von weiteren Bauelementen. Auf der zweiten Seite 32 sind in der Zeichnung jedoch der Übersichtlichkeit wegen keine Lötstellen und Bauelemente dargestellt. An die Kleberschicht 28 ist im Bereich der zweiten Seite 32 die zweite Kernschicht 12' und daran anschließend eine weitere mit Kupfer 18' plattinierte Kupferschicht 16' angeordnet. Den Abschluss nach außen hin bildet eine Lötstoppmaske 20', die in der gezeigten Darstellung lediglich eine Abschlussfläche der Leiterplatte 10 bildet. Die Leiterbahnen der beiden Kupferschichten 16' und 18' bilden die elektrischen Verbindungen in der unteren Schicht 33 (Bottom-Layer) der Leiterplatte 10.

Um von der ersten Seite 30 der Leiterplatte 10 elektrische Verbindungen zur zweiten Seite 32 zu schaffen, sind in der Leiterplatte 10 Durchgangsbohrungen 34 angeordnet, die bevorzugt am Umfang eine elektrisch leitende Beschichtung 36 aufweisen, um eine elektrische Verbindung zwischen den Kupferschichten 14, 16, 18 und 16', 18' zu schaffen.

Die erfindungsgemäße Leiterplatte 10 weist auf der ersten Seite 30 im Bereich der Lötstellen 24 speziell ausgebildete Materialschichten 38, 40 und 42 auf, die sich von den bisher beschriebenen Schichten der übrigen Leiterplatte 10 unterscheiden. So ist im Bereich der Lötstelle 24 auf der Kupferschicht 18 eine elektrisch leitende, elastische Materialschicht 38 angeordnet. Die elektrisch leitende, elastische Materialschicht 38 umfasst vorzugsweise ein Harz, insbesondere ein Epoxidharz, dem elektrisch leitende Partikel beigemischt sind. Die elektrisch leitenden Partikel können z.B. aus Silber oder Kupfer bestehen. Die Elastizität der Materialschicht 38 erlaubt es, während der Herstellung und/oder des Betriebs der Leiterplatte 10 bzw. der darauf realisierten Schaltung entstehende mechanische Belastungen zumindest teilweise zu kompensieren und so die Lebensdauer der Leiterplatte 10 bzw. der darauf angeordneten und kontaktierten Bauelemente 26 zu verlängern.

Auf der elektrisch leitenden, elastischen Materialschicht 38 ist auf einer von der Kupferschicht 18 abgewandten Seite eine Nickelschicht und darauf dann eine Goldschicht 40 angeordnet. Eine solche Nickel-/ Goldschicht 40 ist unter der Bezeichnung ENIG (Electroless Nickel /Immersion Gold) bekannt und ermöglicht ein ordnungsgemäßes Mehrfachlöten an der Luft, ohne dass die Lötverbindung negativ beeinträchtigt wird. Andere Materialien wie z.B. Zinn können das Gold auch ersetzen.

Auf der ENIG-Schicht 40 ist im Bereich der Lötstelle 24 ein Lot 42 aufgetragen, vorzugsweise ein bleifreies Lot (z.B. sog. Innolot). Durch Anordnen und Kontaktieren der Bauteile 26 auf der Lötstelle 24 kann das Lot 42 die Lötstelle 24 verschließen. Beim Verlöten wird das Bauelement 26 mit den daran vorgesehenen Kontaktierungselementen (Footprints) über die elektrisch leitende Lötstelle 24 kontaktiert. Dabei bildet sich eine im Wesentlichen starre Anordnung zwischen dem Bauelement 26 und der Leiterplatte 10. Insbesondere die oberflächenmontierbaren Bauelemente 26 (z.B. Keramikkondensatoren oder QFN-Bauelemente mit entsprechenden Footprints) lassen konstruktionsbedingt nach dem Verlöten in der Regel keine längenausgleichende Bewegung des Bauelements 26 bzw. deren Kontaktierungselemente zu, was z.B. bei Vibrationen und von außen angreifenden Kräften zu mechanischen Belastungen und bei Wärmeunterschieden auf der Leiterplatte 10 im Bereich der Bauelemente 26 zu thermomechanischen Belastungen führen kann.
Die elastische Materialschicht 38 dient dazu, die Leiterplatte 10 im Bereich der Lötstelle 24 gegenüber mechanischen und thermomechanischen Belastungen widerstandsfähiger auszugestalten, da die elastische Materialschicht 38 solche Belastungen zumindest teilweise kompensiert. Die ENIG-Schicht 40 ist elastisch genug, um die Kompensation der Belastungen durch die elastische Materialschicht 38 nicht zu behindern.

Selbstverständlich ist es denkbar, die Anordnung und den mehrschichten Aufbau der Lötstellen sowie die verschiedenen für die Leiterplatte 10 verwendeten Schichten im Rahmen der Erfindung anders auszugestalten als in Figur 1 gezeigt.

## Patentansprüche

1. Leiterplatte (10) für elektrische Schaltungen, wobei die Leiterplatte (10) auf mindestens einer Oberfläche eine Lötstopmaske (20) mit Aussparungen für Lötstellen (24) zum Kontaktieren von elektrischen Bauelementen (26), und Leiterbahnen aufweist, **dadurch gekennzeichnet, dass** mindestens eine der Lötstellen (24) mehrere Schichten (38, 40, 42) aus unterschiedlichen Materialien umfasst und der mehrschichtige Aufbau der Lötstellen (24) sich von dem Aufbau der restlichen Leiterplatte (10) unterscheidet.

2. Leiterplatte (10) nach Anspruch 1, **dadurch gekennzeichnet, dass** mindestens eine Schicht der Lötstellen (24) eine elektrisch leitende, elastische Materialschicht (38) ist.

3. Leiterplatte (10) nach Anspruch 2, **dadurch gekennzeichnet, dass** die elektrisch leitende, elastische Materialschicht (38) ein Harz umfasst.

4. Leiterplatte (10) nach Anspruch 2 oder 3, **dadurch gekennzeichnet, dass** die elektrisch leitende, elastische Materialschicht (38) ein Elastizitätsmodul zwischen 2000 und 6000 N/mm², bevorzugt zwischen 2000 und 3000 N/mm² aufweist.

5. Leiterplatte (10) nach einem der Ansprüche 2 bis 4, **dadurch gekennzeichnet, dass** mindestens eine Schicht der Leiterplatte (10) eine Kupferschicht (14; 16; 18; 16'; 18') ist.

6. Leiterplatte (10) nach Anspruch 5, **dadurch gekennzeichnet, dass** die elektrisch leitende, elastische Materialschicht (38) auf der Kupferschicht (16, 18) angeordnet ist.

7. Leiterplatte (10) nach Anspruch 5 oder 6, **dadurch gekennzeichnet, dass** die Kupferschicht (16) zusätzlich mit Kupfer (18) plattiniert ist.

8. Leiterplatte (10) nach einem der vorhergehenden Ansprüche, **dadurch gekennzeichnet, dass** mindestens eine Schicht der Lötstelle (24) eine Nickelschicht (40) mit einer Gold- oder Zinnauflage ist.

9. Leiterplatte (10) nach Anspruch 8, **dadurch gekennzeichnet, dass** die elektrisch leitende, elastische Materialschicht (38) zwischen einer Kupferschicht (16, 18) und der Nickelschicht (40) mit Gold- oder Zinnauflage angeordnet ist.

10. Leiterplatte (10) nach einem der vorhergehenden Ansprüche, **dadurch gekennzeichnet, dass** die Leiterplatte (10) zur Montage von oberflächenmontierbaren Bauelementen (26) ausgebildet ist.

11. Leiterplatte (10) nach einem der vorhergehenden Ansprüche, **dadurch gekennzeichnet, dass** die Lötstelle (24) mit einem bleifreien Lot (42) bedeckt ist, das zur Kontaktierung der elektrischen Bauelemente (26) dient.
